Europäisches Patentamt

European Patent Office

Office européen des brevets

(11) Publication number: **0 180 461**
A2

# EUROPEAN PATENT APPLICATION

(21) Application number: 85307833.5

(22) Date of filing: 29.10.85

(51) Int. Cl.⁴: **H 03 M 1/86**

(30) Priority: 29.10.84 GB 8427325

(43) Date of publication of application: 07.05.86
Bulletin 86/19

(84) Designated Contracting States: **AT BE CH DE FR IT LI
LU NL SE**

(71) Applicant: **PLESSEY OVERSEAS LIMITED, Vicarage
Lane, Ilford Essex IGI 4AQ (GB)**

(72) Inventor: **Jackson, Thomas, 76 Mallard Place Strawberry
Vale, Twickenham Middlesex (GB)**

(74) Representative: **Sorenti, Gino, Intellectual Property
Department The Plessey Company plc 2-60 Vicarage
Lane, Ilford Essex IG1 4AQ (GB)**

(54) Improvements in or relating to digital to analogue converters.

(57) An interpolating digital to analogue converter 2 comprises
a combiner 4 for receiving a digital input signal. The output sig-
nal of the combiner is fed via a digital controller 6 to one step
quantiser 8. The output signal of the one step quantiser 8 is fed
via a feedback loop 10 to the combiner 4, where it is combined
with the digital input signal, and also to an analogue filter to
provide a voltage output which is proportional to the digital in-
put signal.

The digital controller 6 may comprise an optimum con-
troller, such as a type 1, type 2 or type 3 controller, and is
chosen according to the resolution required.

## IMPROVEMENTS IN OR RELATING TO DIGITAL TO ANALOGUE CONVERTERS

The present invention relates to digital to analogue converters.

One type of digital to analogue (D/A) converter is the resistive ladder type converter. D/A converters of the resistive ladder type require close matching of many resistors, a precision voltage reference and fast settling operational amplifiers to obtain any reasonable degree of resolution and linearity. Even if these requirements are met, there are still the problems of temperature stability, ageing and the high costs involved in fabricating the converters.

Another type of digital to analogue converter is the pulse width modulation type converter in which the digital word is converted to a bit stream having a d.c. level which is porportional to the input word divided by the length of the counter used in the converter. Appropriate analogue filtering of the bit stream yields the required voltage output. Such a converter is cheap, extremely linear, glitch free and simple to devise. It has however the disadvantage that its conversion speed is directly proportional to the counter clock rate divided by the required resolution, or counter length. Hence for any degree of resolution the system needs to be fairly slow. However the inherent linearity and simplicity of this conversion scheme compared to the resistive ladder type of converter makes it fairly attractive.

The present invention proposes to provide a simple and robust D/A converter which has all the advantages of the pulse width modulation type and yet is as fast as the resitive ladder network converters even when high accuracy and resolution is required.

Accordingly there is provided an interpolating digital to analogue converter comprising combiner means for receiving a digital input, digital controller means for receiving an output from the combiner means, digital slicer means for receiving an output from the digital controller means, feedback means for affording the output of the digital slicer means to the combiner means, and output means for affording the output of the digital slicer means to analogue filter means.

The digital controller means may be an optimum digital controller.

The digital controller means may comprise summing means, delay means connected to the summing means, and a feedback loop for affording the output of the delay means to the summing means.

The digital controller means may comprise summing means, first delay means connected to the summing means, second delay means connected to the first delay means, further summing means connected to the second delay means, a feedback loop for affording the output of the further summing means to the summing means, and a feed forward loop, including multiplier means, for affording an output from the first delay means to the further summing means.

The digital controller may comprise summing means, first delay means connected to the summing means, second delay means connected to the first delay means, third delay means connected to th second delay means, further summing means connected to the third delay means, a feedback loop for affording the output of the further summing means to the summing means, a first feed forward loop, including first multiplier means, for affording an output from the first delay means to the further summing means, and a second feed forward loop, including second multiplier means, for affording an output from the second delay means to the further summing means.

The delay means may comprise D-type flip-flops.

The present invention will now be described, by way of example, with reference to the accompanying drawings in which:

Figure 1 is a schematic block diagram of a digital to analogue converter incorporating a one bit quantiser;

Figure 2 is a schematic block diagram of the noise model of the digital to analogue converter shown in Figure 1;

Figure 3 illustrates a schematic block diagram of the digital to analogue converter shown in Figure 1 and incorporating a type 1 digital controller;

Figure 4 illustrates a schematic block diagram of the digital to analogue converter as shown in Figure 1 and incorporating a type 2 digital controller; and

Figure 5 illustrates a schematic block diagram of the digital to analogue converter shown in Figure 1 and incorporating a type 3 digital controller.

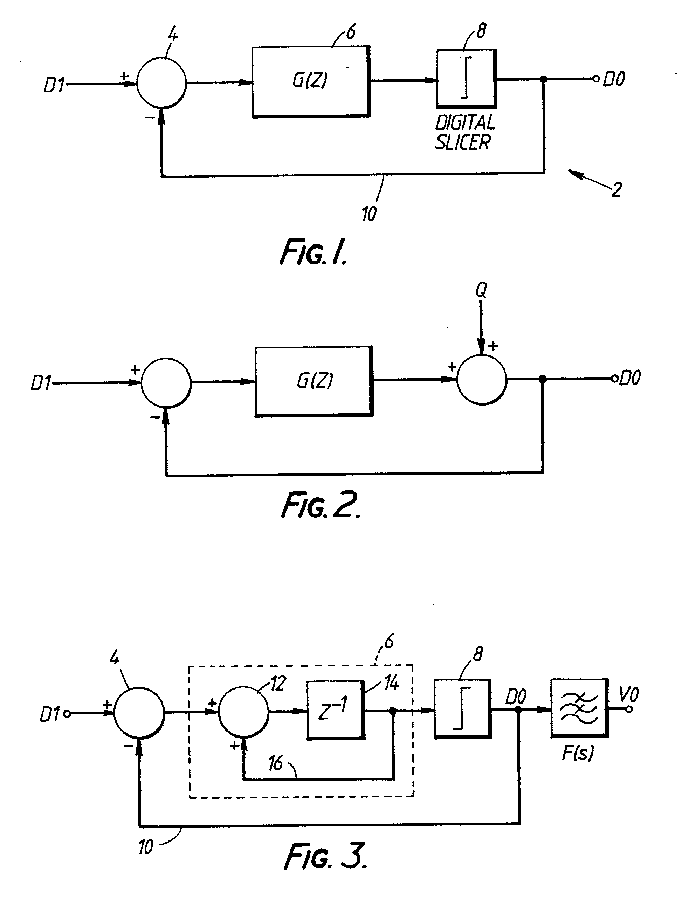

Referring to Figure 1, a D/A converter 2 comprises combiner means 4, which may take the form of an X-bit adder, for receiving a digital input D1. The combiner means 4 is connected to digital controller means 6, the output of which is connected to a one bit quantiser in the form of digital slicer means 8. Feedback means is provided, in the form of a digital feedback control loop 10, between the output of the digital slicer 8 and the combiner means 4.

The D/A converter shown in Figure 1 limit cycles to produce an output bit stream Do which has a mean mark to space ratio proportional to the digital input word. This output bit stream may be analogue filtered to a voltage which is directly proportional to the input word. Figure 2 illustrates the noise model of the D/A converter 2 where Q is the quantisation error of the one bit quantiser 8 shown in Figure 1.

If G(z) is the gain of the digital controller means 6 then:

$$Do(z) = \frac{Dl(z)G(z)}{1 + G(z)} + \frac{Q(z)}{1 + G(z)} \qquad (1)$$

From this expression it can be seen that as G(z) tends towards infinity, the error term due to Q tends to zero. Hence a D/A converter of any resolution may be produced by choosing the appropriate value of G(z) and then analogue filtering the subsequent output of the one bit quantiser 8.

The error, or noise term Eq(z) of the D/A converter 2 may be expressed as:

$$Eq(z) = \frac{Q(z)}{1+G(z)} \qquad (2)$$

The D/A converter 2 may be analysed as follows:

Let: $\dfrac{Do(z)}{Dl(z)} = M(z)$

then the gain of the digital controller means 6:

$$G(z) \quad = \quad \frac{M(z)}{1-M(z)} \qquad\qquad (3)$$

It can be seen that equation (3) determines the open loop gain of the D/A converter and it is maximised by choosing the fastest closed loop response to a given type of input; such as by the use of an optimum controller for the digital controller means 6, the optimum value for $G(z)$ occurring when the closed loop exhibits a "Deadbeat" response. "Deadbeat" response is described in detail in section 10.8 of "Digital Control Systems" by Benjamin C. Kuo published by Holt/Saunders International Editions, the subject matter of which is incorporated herein by reference. Increasing the type of loop allows greater reduction of Eq (the error or noise term of the D/A converter 2), for a given bandwidth $F_L$ of the analogue filter means at a clock rate $F_S$ of the D/A converter 2. Table A below shows the required controller $G(z)$ for maximum reduction of the noise term Eq for three types of loop.

## TABLE A

| LOOP TYPE | IMPULSE RESPONSE $M(z)$ | DIGITAL CONTROLLER $G(z)$ |
|---|---|---|
| 1 | $z^{-1}$ | $\dfrac{z^{-1}}{1-z^{-1}}$ |
| 2 | $2z^{-1}-z^{-2}$ | $\dfrac{2z^{-1}-z^{-2}}{1-2z^{-1}+2^{-2}}$ |
| 3 | $3z^{-1}-3z^{-2}+z^{-3}$ | $\dfrac{3z^{-1}-3z^{-2}+z^{-3}}{1-3z^{-1}+3z^{-2}-z^{-3}}$ |

Where $z^{-1}$ is a delay of 1 sample period.

Suitable digital controllers for use in the analogue to digital converter 2, of which the type 1, 2 and 3 optimum controllers referred to in Table A are merely illustrative, are described in detail in Chapter 17 of "Feedback Control System Analysis and Synthesis" by J.J. D'Azzo and C.H. Houpis published by McGraw Hill, the subject matter of which is incorporated herein by reference.

The respective loop block diagrams for type 1, type 2 and type 3 digital controllers can be seen from, respectively, Figures 3, 4 and 5, which illustrate a D/A

-8-

converter incorporating type 1, type 2, and type 3 optimum digital controllers as the digital controller means 6.

It can be seen from Figure 3 that the type 1 digital controller comprises summing means 12 in combination with delay means 14 and a feedback loop 16 connecting the output of the delay means 14 to the summing means 12.

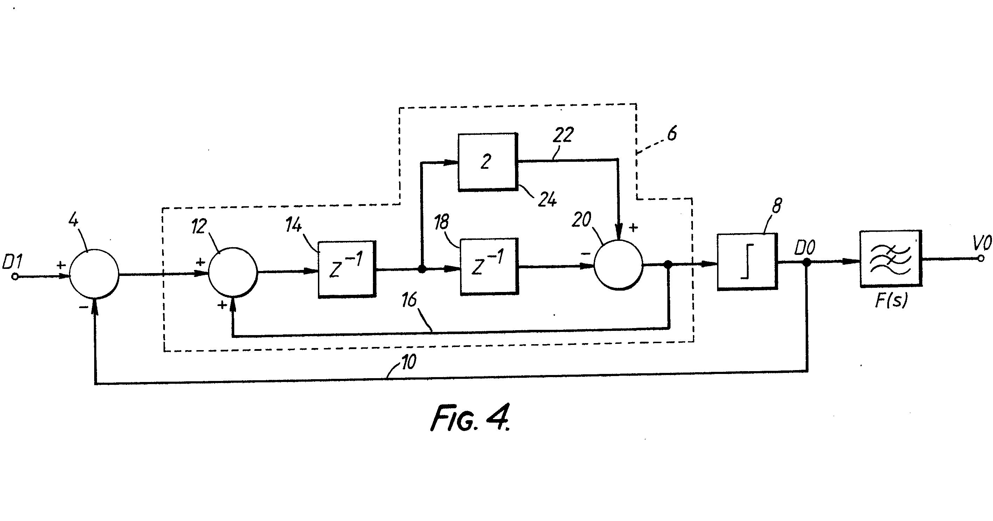

The type 2 digital controller, shown in Figure 4 includes a second delay means 18, further summing means 20 and a feed forward loop 22 including a multiplier 24.

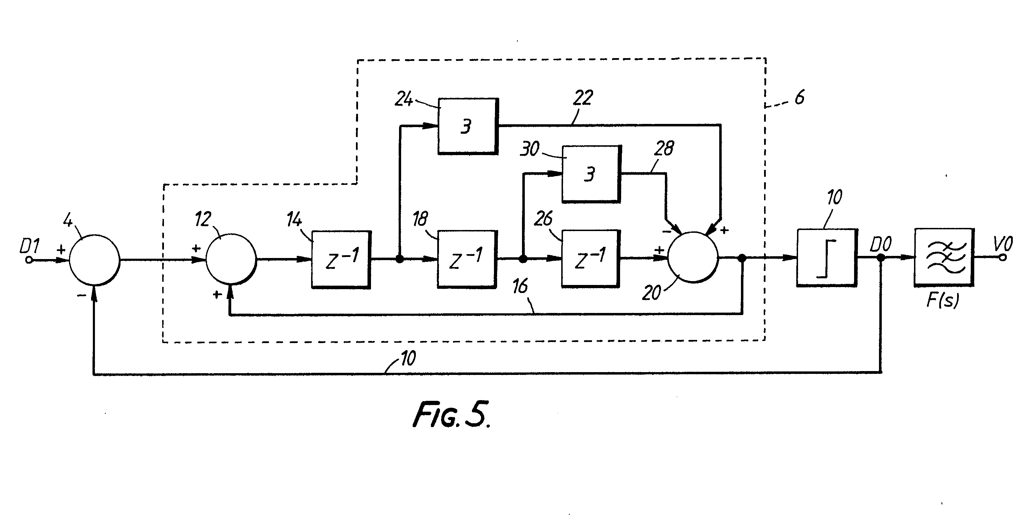

The type 3 digital controller, shown in Figure 5 includes a third delay means 26 and a second feed forward loop 28 including a multiplier 30. The delay means 14, 18 and 26 used in these controllers may comprise D-type flip-flops.

The resolution in bits $N_{OUT}$ for a given type of loop that is, whether the loop incorporates a type 1, type 2, type 3 etc digital controller is given in equation (4) below:

$$N_{OUT} = \log_2\left\{\left[\sqrt{\frac{1+V^2}{2V}}\right] T \sqrt{\frac{3(2T+1)\ Fs}{FL}}\right\} \quad (4)$$

where: $V = \tan\left(\frac{\pi FL}{Fs}\right)$

$T$ = type of loop (1, 2, 3 ..... etc.)

The resolution obtained by applying this equation to a digital to analogue converter incorporating a type 1, 2 or 3 controller is shown in Table B.

-9-

**TABLE B**

|  | TYPE 3 | TYPE 2 | TYPE 1 | $\frac{FL}{FS}$ |
|---|---|---|---|---|
| RESOLUTION | 6.0 | 5.0 | 3.0 | 0.1 |
| N $_{OUT}$ | 17.5 | 13.3 | 8.9 | 0.01 |
|  | 29.12 | 21.6 | 13.9 | 0.001 |
|  | 40.75 | 29.9 | 18.9 | 0.0001 |

From equation (2):

$$Eq = \frac{Q}{1+G(z)}$$

Taking the bilinear transform of this expression gives:

$$Eq = Q \left( \frac{2w}{1+w} \right)^T$$

This shows that the noise Q is shaped by a high pass filter of characteristic:

$$F(w) = \left( \frac{2w}{1+w} \right)^T$$

The analogue filter used at the output of the D/A converter 2 must therefore have an order greater than this to realise the possible D/A resolution. It can be seen from this expression that choosing a filter having a Butterworth characteristic will only result in a loss of approximately 2 dB in resolution when compared to an ideal filter.

If the clock rate Fs = 10 MHz and the bandwidth of the analogue filter FL = 100 kHz then it can be seen from equation (4) above that a Type 3 loop is required to achieve a converter having 17 bits resolution.

The output filter Butterworth response is:

$$F(s) = \frac{wo^4}{s^4 + 2.6wos^3 + 3.4wo^2s^2 + 2.6wo^3s + wo^4}$$

where wo = $2\pi F_L$

This output filter can either be a low noise active filter or a passive LC type of filter.

The settling time of the analogue output filter can be expressed as

$$\frac{Ln2^{NOUT}}{2\pi FL}$$

Substituting the above value in this expression gives a settling time of approximately 19/uS at 17 bits resolution.

It can be seen, therefore, that the present invention provides extremely linear and fairly fast D/A converters which can be realised cheaply and easily and having a performance which rivals conventional ladder network types.

0180461

-11-

A D/A converter 2 in accordance with the present invention and incorporating a Type 3 digital controller may be realised on any integrated circuit gate array and provides a programmable, robust and linear D/A converter with speeds and accuracy matching conventional high precision open loop converters.

D/A converters in accordance with the present invention may be utilised in any application where high resolution is required such as, for example, high resolution graphics or high quality audio equipment.

Although the present invention has been described with respect to a particular embodiment, it should be understood that modifications may be effected within the scope of the invention.

-12-

CLAIMS:

1. An interpolating digital to analogue converter characterised by combiner means (4) for receiving a digital input, digital controller means (6) for receiving an output from the combiner means (4), digital slicer means (8) for receiving an output from the digital controller means, feedback means (10) for affording the output of the digital slicer means to the combiner means (4) and output means for affording the output of the digital slicer means to analogue filter means.

2. An interpolating digital to analogue converter according to claim 1 characterised in that the digital controller (6) comprises summing means (12) for receiving the output from the combiner means (4), delay means (14) coupled to the summing means (12), and a feedback loop for affording the output of the delay means (14) to the summing means (12).

3. An interpolating digital to analogue converter according to claim 1 characterised in that the digital controller means (6) comprises summing means (12) for receiving the output from the combiner means (4), first delay means (14) coupled to the summing means (12), second delay means (18) coupled to the first delay means (14), further summing means (20) coupled to the second delay means (18), a feedback loop (16) for affording the output of the further summing means (20) to the summing means (12), and a feed forward loop (22), including multiplier means (24), for affording an output from the first delay means (14) to the further summing means (20).

4. An interpolating digital to analogue converter according to claim 1 characterised in that the digital controller means (6) comprises summing means (12) for receiving the output from the combiner means (4), first delay means (14) coupled to the summing means (12), second delay means (18) coupled to the first delay means (14), third delay means (26) coupled to the second delay means (18), further summing means (20) coupled to the third delay means (18), a feedback loop (16) for affording the output of the further summing means (20) to the summing means (12), a first feed forward loop (22), including first multipler means (24), for affording an output from the first delay means (14) to the further summing means (20), and a second feed forward loop (28), including second multiplier means (30), for affording an output from the second delay means (18) to the further summing means (20).

-14-

5.    An interpolating digital to analogue converter according to any one of claims 2,3 or 4 wherein the delay means (14, 18, 26) comprise D-type flip-flops.

6.    An integrated circuit device comprising a digital to analogue converter according to any one of the preceding claims.

1/3

FIG. 1.

FIG. 2.

FIG. 3.

Fig. 4.

0180461

Fig.5.